# EUROPEAN PATENT APPLICATION

(11) **EP 4 704 515 A1**
(43) Date of publication of application: **04.03.2026**
(21) Application number: 24197302.3
(22) Date of filing: 29.08.2024
(51) Int. Cl.: H10D 30/01, H10D 12/00, H10D 30/66, H10D 30/83, H10D 62/10, H10D 62/17, H10D 64/23

(54) **INSULATED GATE FIELD EFFECT TRANSISTOR INCLUDING TRENCH STRUCTURE**

(71) Applicant: Infineon Technologies Austria AG, 9500 Villach (AT)
(72) Inventor: FISCHER, Björn, 81547 München (DE); SIEMIENIEC, Thomas Ralf, 9500 Villach (AT); WEBER, Hans, 9500 Villach (AT); KAMMERLANDER, David, 9500 Villach (AT); POPESCU, Dan Horia, 81245 München (DE)
(74) Representative: Müller Hoffmann & Partner

(57) **Abstract**

An insulated gate field effect transistor, IGFET (100) is proposed. The IGFET (100) includes a trench structure (102) extending, along a vertical direction (y), into a wide band gap semiconductor body (104) from a first surface (1061) of the wide band gap semiconductor body (104). The IGFET further includes a body region (108) of a first conductivity type, a source region (110) of a second conductivity type, and a shielding region (112) of the first conductivity type. The shielding region (112) includes a first sub-region (1121) adjoining a bottom side of the trench structure (102). The shielding region (112) further includes a second sub-region (1122) adjoining a bottom side (113) of the first sub-region (1121). The first sub-region (1121) has a larger maximum doping concentration than the second sub-region (1122). A vertical doping concentration profile of the first sub-region (1121) and a vertical doping concentration profile of the second sub-region (1122) overlap each other at the bottom side (113) of the first sub-region (1121).

## Description

### TECHNICAL FIELD

The present disclosure is related to a semiconductor device, in particular to an insulated gate field effect transistor, IGFET, including a trench structure.

### BACKGROUND

Technology development of new generations of semiconductor devices, e.g. IGFETs, aims at improving electric device characteristics and reducing costs by shrinking device geometries. Although costs may be reduced by shrinking device geometries, a variety of tradeoffs and challenges have to be met when increasing device functionalities per unit area. For example, a trade-off between area-specific on-state resistance, RₒₙxA, and reliability requirements influenced by, for example, electric breakdown capability, requires design optimization.

Thus, there is a need for an improved insulated gate field effect transistor.

### SUMMARY

An example of the present disclosure relates an insulated gate field effect transistor, IGFET. The IGFET includes a trench structure extending, along a vertical direction, into a wide band gap semiconductor body from a first surface of the wide band gap semiconductor body. The IGFET further includes a body region of a first conductivity type. The IGFET further includes a source region of a second conductivity type. The IGFET further includes a shielding region of the first conductivity type. The shielding region includes a first sub-region adjoining a bottom side of the trench structure. The shielding region further includes a second sub-region adjoining a bottom side of the first sub-region. The first sub-region has a larger maximum doping concentration than the second sub-region. A vertical doping concentration profile of the first sub-region and a vertical doping concentration profile of the second sub-region overlap each other at the bottom side of the first sub-region.

A further example of the present disclosure relates to a method of manufacturing an insulated gate field effect transistor, IGFET. The method includes forming a trench structure extending, along a vertical direction, into a wide band gap semiconductor body from a first surface of the wide band gap semiconductor body. The method further includes forming a body region of a first conductivity type. The method further includes forming a source region of a second conductivity type. The method further includes forming a shielding region of the first conductivity type. The shielding region includes a first sub-region adjoining a bottom side of the trench structure. The shielding region further includes a second sub-region adjoining a bottom side of the first sub-region. The first sub-region has a larger maximum doping concentration than the second sub-region. A vertical doping concentration profile of the first sub-region and a vertical doping concentration profile of the second sub-region overlap each other at the bottom side of the first sub-region.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of IGFETs and together with the description serve to explain principles of the examples. Further examples are described in the following detailed description and the claims.
Fig. 1 is an exemplary process illustration of manufacturing an IGFET including a shielding region.
Figs. 2A and 2B are schematic cross-sectional views for illustrating process features of forming the shielding region.
Figs. 3 and 4 are schematic cross-sectional views for illustrating configuration examples of an IGFET including a trench structure and a shielding region.
Figs. 5A and 5B are graphs for illustrating exemplary vertical profiles of doping concentration of the shielding region.
Fig. 6 is a schematic cross-sectional view for illustrating a configuration example of a vertical junction field effect transistor, VJFET including a trench structure and a shielding region.

### DETAILED DESCRIPTION

In the following detailed description, reference is made to the accompanying drawings, which form a part hereof and in which are shown by way of illustrations specific examples of IGFETs. It is to be understood that other examples may be utilized and structural or logical changes may be made without departing from the scope of the present disclosure. For example, features illustrated or described for one example can be used in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive connection between electrically connected elements, for example a direct contact between the concerned elements or a low-resistive connection via a metal and/or heavily doped semiconductor material. The term "electrically coupled" includes that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact is a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example relates to an insulated gate field effect transistor, IGFET. The IGFET includes a trench structure extending, along a vertical direction, into a wide band gap semiconductor body from a first surface of the wide band gap semiconductor body. The IGFET further includes a body region of a first conductivity type. The IGFET further includes a source region of a second conductivity type. The IGFET further includes a shielding region of the first conductivity type. The shielding region includes a first sub-region adjoining a bottom side of the trench structure. The shielding region further includes a second sub-region adjoining a bottom side of the first sub-region. The first sub-region has a larger maximum doping concentration than the second sub-region. A vertical doping concentration profile of the first sub-region and a vertical doping concentration profile of the second sub-region overlap each other at the bottom side of the first sub-region.

The IGFET may be part of an integrated circuit or may define a discrete semiconductor device or a semiconductor module, for example. For example, the IGFET may be a vertical-channel IGFET. In a vertical-channel IGFET, a load current flow is between a first load electrode, e.g. source electrode, over the first surface of the semiconductor body and a second load electrode, e.g. drain electrode, over a second surface opposite to the first surface along the vertical direction. In the vertical-channel IGFET, a load current may flow along the vertical direction perpendicular to the first and/or second surface. The IGFET may be used in applications related to power transmission and distribution, automotive and transport, renewable energy, consumer electronics, and other industrial applications, for example.

The first surface may be a front surface or a top surface of the semiconductor body, and the second surface may be a back surface or a rear surface of the semiconductor body, for example. For example, the semiconductor body may be attached to a lead frame via the second surface, for example. Over the first surface of the semiconductor body, bond pads may be arranged and bond wires may be bonded on the bond pads, for example.

The IGFET may be configured to conduct currents of more than 1A or more than 10 A or even more than 100 A. For example, the IGFET may be designed as a transistor cell array of a plurality of transistor cells having a same layout. The transistor cell array may be a 1-dimensional or a 2-dimensional regular arrangement of the plurality of transistor cells. For example, the plurality of transistor cells of the transistor cell array may be electrically connected in parallel. For example, source regions of the plurality of transistor cells of the IGFET transistor cell array may be electrically connected together. Likewise, drain regions of the plurality of transistor cells of the IGFET transistor cell array may be electrically connected together. For example, gate regions of the plurality of transistor cells of the IGFET transistor cell array may be electrically connected together. A transistor cell of the transistor cell array or a part thereof, e.g. the gate region, may be designed in the shape of a stripe, a polygon, a circle or an oval, for example.

A number of transistor cells of the transistor cell array may depend on the maximum load current, for example. For example, a number of transistor cells of the transistor cell array may be larger than 100, or larger than 1000, or even larger than 10000, for example. The IGFET may be further configured to block voltages between the load electrodes, e.g. between drain and source of the IGFET, of more than 60V, 100V, 400 V, 650V, 1.2kV, 1.7kV, 3.3kV, 4.5kV, 5.5kV, 6kV, 6.5kV, 10kV. The blocking voltage may correspond to a voltage class specified in a datasheet of the IGFET, for example. The blocking voltage of the IGFET may be adjusted by an impurity concentration and/or a vertical extension of a drift region in the semiconductor body. A doping concentration of the drift region may gradually or in steps increase or decrease with increasing distance to the first surface at least in portions of its vertical extension. According to other examples the impurity concentration in the drift region may be approximately uniform. When operating the IGFET in voltage blocking mode, a space charge region may vertically extend partly or totally through the drift region depending on the blocking voltage applied to the IGFET.

The semiconductor device may be based on a wide band gap semiconductor body from a crystalline wide band gap semiconductor material having a band gap larger than the band gap of silicon, i.e. larger than 1.12 eV. The wide band gap semiconductor material may have a hexagonal crystal lattice and may be silicon carbide (SiC), by way of example. For example, the semiconductor material may be 2H-SiC (SiC of the 2H polytype), 6H-SIC or 15R-SiC. According to an example, the semiconductor material is silicon carbide of the 4H polytype (4H-SiC). The semiconductor body may include or consist of a semiconductor substrate having none, one or more than one semiconductor layers, e.g. epitaxially grown layers, thereon. One of the semiconductor layers may be a doped semiconductor layer of a current spread layer, for example. As an alternative to a SiC semiconductor body, gallium arsenide (GaAs) or gallium nitride (GaN) may be used as a material of the wide band gap semiconductor body, for example.

For example, the source region may be electrically connected to a source electrode of the IGFET. The source electrode may be arranged over the first surface of the semiconductor body and may be part of a wiring area over the semiconductor body. The wiring area may include one or more than one, e.g. two, three, four or even more wiring levels. Each wiring level may be formed by a single one or a stack of conductive layers, e.g. metal layer(s). The wiring levels may be lithographically patterned, for example. Between stacked wiring levels, an interlayer dielectric structure may be arranged. Contact plug(s) or contact line(s) may be formed in openings in the interlayer dielectric structure to electrically connect parts, e.g. metal lines or contact areas, of different wiring levels to one another. The source electrode may be formed by one or more elements of the wiring area over the first surface. Likewise, a drain electrode may be formed by one or more elements of a wiring area over the second surface of the wide band gap semiconductor body, for example.

For example, dopants in a semiconductor body comprising SiC may include Al, B, Be, Ga, or any combination thereof for p-type doping, an N, P, or any combination thereof for n-type doping. For example, dopants in a semiconductor body comprising Si may include Al, B, Ga, In, or any combination thereof for p-type doping, an P, As, Sb, hydrogen-related donors, or any combination thereof for n-type doping.

The shielding region including the first and second sub-regions according to the configuration examples described herein allow for a number of technical benefits. For example, shielding of the gate dielectric or an electrode in the trench structure from electric fields extending into the shielding region may be adjusted by using a combination of a low dose region, e.g. the second sub-region, and a high dose region, e.g. the first sub-region, in the prescribed order. Moreover, defect regions in the high dose region, e.g. the first sub-region, may be shielded from the electric field by the low dose region, e.g. the second sub-region. Moreover, the high dose region, e.g. the first sub-region, may enable a low-ohmic connection to the screening potential or even a doping level for ohmic contacts.

For example, a vertical doping concentration profile of the second sub-region, starting from the bottom side of the first sub-region, e.g. high dose region, may correspond to a space charge per unit area larger than 0.95 times a breakdown charge per unit area of the wide band gap semiconductor body. This may allow for screening the high dose region, e.g. the first sub-region that may include defects caused by a high dose ion implantation, from high electric fields. Thereby, undesired degradation of electric parameters, e.g. leakage current, may be avoided or counteracted.

For example, the wide band gap semiconductor body may be a silicon carbide semiconductor body. A maximum doping concentration of the first sub-region, along the vertical direction starting from the bottom side of the trench structure, may be larger than 2 x 10¹⁸ cm⁻³, or larger than 5 x 10¹⁸ cm⁻³. A maximum doping concentration of the second sub-region, along the vertical direction starting from the bottom side of the first sub-region, may be smaller than 2 x 10¹⁸ cm⁻³. This may support shielding a gate dielectric or electrode in the trench structure from electric fields while securing a low-ohmic connection to the screening potential or even a doping level for ohmic contacts.

For example, the vertical doping concentration profile of the second sub-region, along the vertical direction starting from the bottom side of the first sub-region, may include at least one peak P having a vertical distance d to the bottom side of the first sub-region. For example, the at least one peak may be formed by an ion implantation process of dopants through a bottom side of a trench of the trench structure. An ion implantation energy of dopants for forming the second sub-region may be larger than an ion implantation energy of dopants for forming the first sub-region.

For example, the maximum doping concentration of the second sub-region, along the vertical direction starting from the bottom side of the first sub-region, may be located at a transition to the first sub-region at the bottom side of the first sub-region. Thus, the profile of the doping concentration of the second sub-region may be shaped as a shoulder vertically extending from the first sub-region. This may be caused by, for example, an ion implantation process of dopants for forming the second sub-region that has a peak located around the transition to the first sub-region or even in the first sub-region.

For example, the trench structure may be a trench gate structure including a trench gate dielectric and a trench gate electrode. The trench gate dielectric may be formed by or may include an oxidation process, e.g. thermal oxidation process and/or oxide deposition process. Other dielectric materials may be used in addition to or as an alternative to the oxide. For example, high-k materials may be used. For example, the trench gate dielectric layer may include a high-k dielectric layer including at least one of Al₂O₃, ZrO₂, HfO₂, AIN, alumosilicate AlSiOx, silicon La- or Si-doped HfO₂, TiO₂, Y₂O₃, or Si₃N₄. For example, the trench gate dielectric may include at least a first dielectric sub-layer and a second dielectric sub-layer. The first dielectric sub-layer adjoining to a channel region may have a dielectric constant that is smaller than the dielectric constant of the high-k dielectric sub-layer, e.g. be equal to or larger than the dielectric constant of SiO₂. For example, the first dielectric layer may include at least one of SiO₂, AIN, or Si₃N₄, for example. The trench gate electrode may include one or more conductive material(s), e.g. metal, metal alloys, e.g. Cu, Au, AlCu, Ag, or alloys thereof, metal compounds, e.g. TiN, highly doped semiconductor material such as highly doped polycrystalline silicon. The one or more conductive materials may form a layer stack, for example. The trench gate electrode may be electrically connected to a gate pad via a gate interconnection structure such as a gate runner, for example. The gate pad/interconnection structure and, for example, a first load electrode pad, e.g. a source pad of the IGFET, may be part of a wiring area over the wide band gap semiconductor body.

For example, the source region may adjoin a first sidewall of opposite first and second sidewalls of the trench gate structure. The body region may adjoin the first sidewall of the trench gate structure. The shielding region may adjoin the second sidewall the trench gate structure. The IGFET may thus have a one-sided channel region. The shielding region may extend from below a bottom side of the trench gate structure along the second sidewall of the trench gate structure up to a contact region at the first surface of the wide band gap semiconductor body.

For example, the first sub-region at the bottom side of the trench structure may be bounded, along a first lateral direction, by opposite portions of the second sub-region. In other words, the first sub-region may be lined with the second sub-region. A transition or interface between the first sub-region and the second sub-region may vertically extend from a bottom side of the trench structure and perform a U-turn. After the U-turn, the transition or interface may extend up to or close to or toward the first surface of the wide band gap semiconductor body, e.g. parallel to the second sidewall of the trench gate structure.

For example, the trench structure may be a contact trench structure including a contact material electrically coupled to the shielding region. The contact material may include one or more conductive material(s), e.g. metal, metal alloys, e.g. Cu, Au, AlCu, Ag, or alloys thereof, metal compounds, e.g. TiN, highly doped semiconductor material such as highly doped polycrystalline silicon. The one or more conductive materials may form a layer stack, for example. The contact material may be electrically connected to a first load electrode, e.g. source electrode, of the IGFET.

For example, the IGFET including the contact trench structure may further include a trench gate structure extending, along the vertical direction, into the wide band gap semiconductor body from the first surface of the wide band gap semiconductor body. The trench gate structure includes a trench gate dielectric and a trench gate electrode. The trench gate dielectric may be formed by or may include an oxidation process, e.g. thermal oxidation process and/or oxide deposition process. Other dielectric materials may be used in addition to or as an alternative to the oxide. For example, high-k materials may be used. For example, the trench gate dielectric layer may include a high-k dielectric layer including at least one of Al₂O₃, ZrO₂, HfO₂, AIN, alumosilicate AlSiOx, silicon La- or Si-doped HfO₂, TiO₂, Y₂O₃, or Si₃N₄. For example, the trench gate dielectric may include at least a first dielectric sub-layer and a second dielectric sub-layer. The first dielectric sub-layer adjoining to a channel region may have a dielectric constant that is smaller than the dielectric constant of the high-k dielectric sub-layer, e.g. be equal to or larger than the dielectric constant of SiOz. For example, the first dielectric layer may include at least one of SiO₂, AIN, or Si₃N₄, for example. The trench gate electrode may include one or more conductive material(s), e.g. metal, metal alloys, e.g. Cu, Au, AlCu, Ag, or alloys thereof, metal compounds, e.g. TiN, highly doped semiconductor material such as highly doped polycrystalline silicon. The one or more conductive materials may form a layer stack, for example. The trench gate electrode may be electrically connected to a gate pad via a gate interconnection structure such as a gate runner, for example. The gate pad/interconnection structure and, for example, a first load electrode pad, e.g. a source pad of the IGFET, may be part of a wiring area over the wide band gap semiconductor body. A portion of the body region may be bounded, along a first lateral direction, by the trench gate structure and the shielding region. A portion of the shielding region may be bounded, along the first lateral direction, by the body region and the trench structure.

For example, the IGFET may further include a current spread region of the second conductivity type and a drift region of the second conductivity type. The current spread region may be arranged, along the vertical direction, between the body region and the drift region. A maximum doping concentration of the current spread region may be larger than a maximum doping concentration of a portion of the drift region adjoining a bottom side of the current spread region. For example, a bottom side of the shielding region may have a vertical distance from the first surface that is larger than a vertical distance of a bottom side of the current spread region from the first surface. A vertical distance of the bottom side of the trench structure from the first surface may be larger than a vertical distance of a top side of the current spread region from the first surface.

Details with respect to structure, or function, or technical benefit of features described above with respect to a wide band gap semiconductor device such as an IGFET likewise apply to the exemplary methods described further below. Processing the wide band gap semiconductor body may comprise one or more optional additional features corresponding to one or more aspects mentioned in connection with the proposed concept or one or more examples described above or below.

Some of the above and below examples are described in connection with a silicon carbide substrate. Alternatively, a wide band gap semiconductor substrate, e.g. a wide band gap wafer, may be processed, e.g. comprising a wide band gap semiconductor material different from silicon carbide. The wide band gap semiconductor wafer may have a band gap larger than the band gap of silicon (1.12 eV). For example, the wide band gap semiconductor wafer may be a silicon carbide (SiC) wafer, or gallium arsenide (GaAs) wafer.

In the illustrated examples, n-channel IGFETs, e.g. MOSFETs, are illustrated. However, the examples described herein may also be applied to p-channel devices, e.g. p-channel MOSFETs.

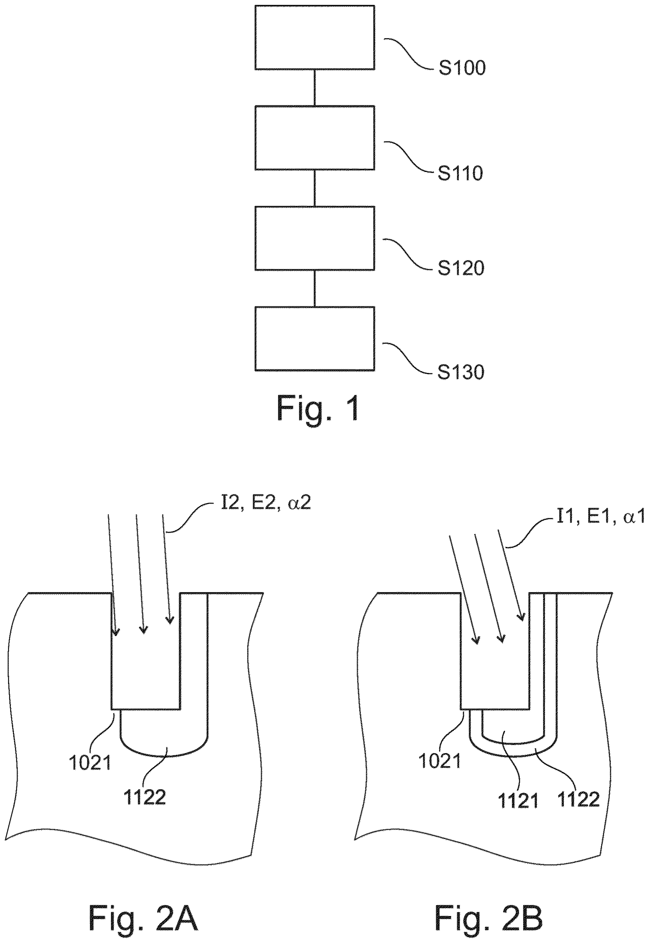

The process illustration of Fig. 1 refers to process features of forming an IGFET.

Process feature S100 includes forming a trench structure extending, along a vertical direction, into a wide band gap semiconductor body from a first surface of the wide band gap semiconductor body.

Process feature S110 includes forming a body region of a first conductivity type.

Process feature S120 includes forming a source region of a second conductivity type.

Process feature S130 includes forming a shielding region of the first conductivity type, wherein the shielding region includes a first sub-region adjoining a bottom side of the trench structure, and a second sub-region adjoining a bottom side of the first sub-region, the first sub-region having a larger maximum doping concentration than the second sub-region, and wherein a vertical doping concentration profile of the first sub-region and a vertical doping concentration profile of the second sub-region overlap each other at the bottom side of the first sub-region.

It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, - processes, -operations or-steps, respectively. Such sub acts may be included and part of the disclosure of this single act unless explicitly excluded. For example, in the exemplary method described above, the trench structure may be formed after forming the body region and/or the source region and/or the shielding region. Each of the trench structure and the shielding region or any combination of structural features to be formed by above process features S100 to S130 may be formed by a plurality of sub-processes that may be intermixed in an sequence depending on the requirements of the target process.

For example, forming the first sub-region may include at least one ion implantation process having a first ion implantation energy and a first ion implantation angle and forming the second sub-region may include at least one ion implantation process having a second ion implantation energy and a second ion implantation angle. The at least one ion plantation process for forming the first sub-region and/or the at least one ion plantation process for forming the second sub-region may introduce dopants through a bottom side and/or a sidewall of a trench of the trench structure, for example.

The schematic cross-sectional views of Figs. 2A and 2B illustrate exemplary process features of forming the shielding region.

Referring to Fig. 2A, a second sub-region 1122 of the shielding region 112 is formed by at least one ion implantation process I2 having an ion implantation energy E2 and an ion implantation tilt angle α2. Dopants of the at least one ion implantation process I2 are introduced through a bottom side/sidewall of a trench 1021.

Referring to Fig. 2B, a first sub-region 1121 of the shielding region 112 is formed by at least one ion implantation process I1 having a first ion implantation energy E1 and a first ion implantation tilt angle α1. Dopants of the at least one ion implantation process I1 are introduced through a bottom side/sidewall of the trench 1021. The trench 1021 may be further processed to a trench structure at a later process stage.

The sequence of forming the first and second sub-regions 1121 and 1122 may also be reversed with respect to Figs. 2A and 2B.

For example, the second ion implantation energy E2 may be at least 50 % larger than the first ion implantation energy E1. The second ion implantation tilt angle α2 may be smaller than the first ion implantation angle α1.

For example, a total ion implantation dose of the at least one ion implantation process for forming the second sub-region may be in a range from 3 x 10¹³ cm⁻² to 1 x 10¹⁴ cm⁻².

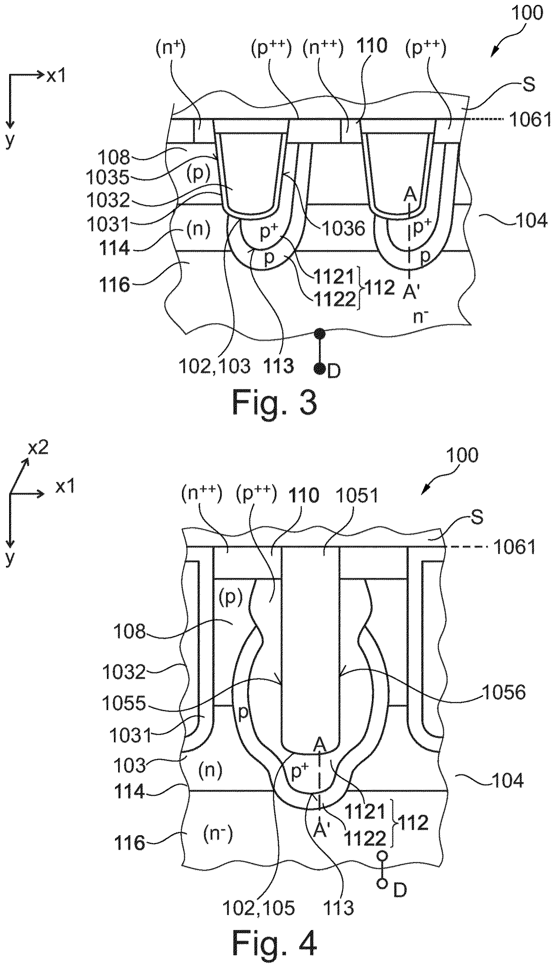

A configuration example of an IGFET 100 is illustrated in the schematic cross-sectional view of Fig. 3. The IGFET 100 is an example of an IGFET having a one-sided channel region.

The IGFET 100 includes a trench structure 102 extending, along a vertical direction y, into a wide band gap semiconductor body 104, e.g. SiC semiconductor body, from a first surface 1061 of the wide band gap semiconductor body 104. The trench structure 102 is configured as a trench gate structure 103. The trench gate structure 103 includes a trench gate dielectric 1031 and a trench gate electrode 1032.

The IGFET 100 further includes an n⁺-doped source region 110 adjoining a first sidewall 1035 of the trench gate structure 103. A second sidewall 1036 of the trench gate structure 103 is opposite to the first sidewall. The n⁺-doped source region 110 is omitted at the second sidewall 1036 of the trench gate structure 103 for forming a one-sided channel region. A p-doped body region 108 adjoins the first sidewall 1035 of the trench gate structure 103.

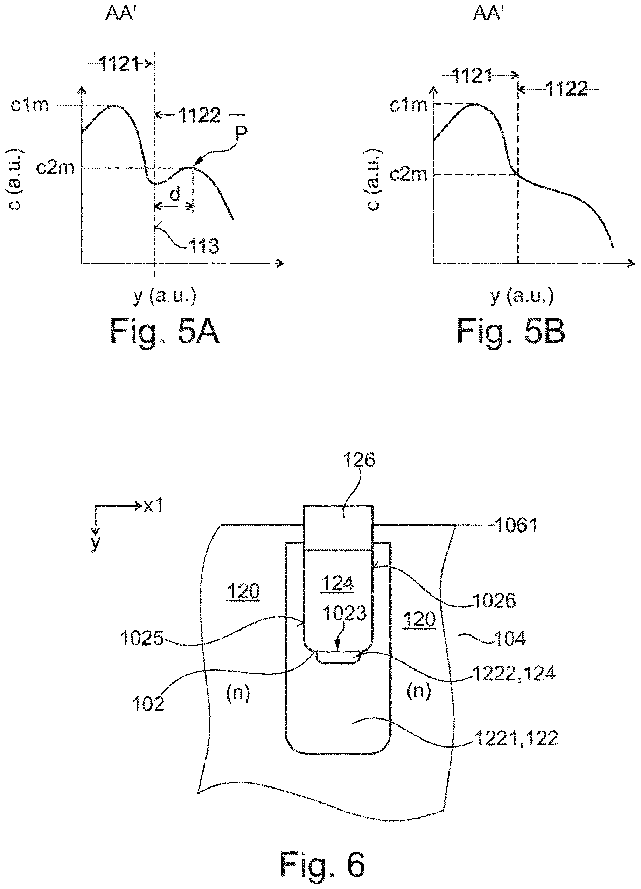

The IGFET 100 further includes a p-doped shielding region 112. The shielding region 112 includes a first sub-region 1121 adjoining a bottom side of the trench structure 102. The shielding region 112 further includes a second sub-region 1122 adjoining a bottom side 113 of the first sub-region 1121. A maximum doping concentration of the first sub-region 1121 is larger than a maximum doping concentration of the second sub-region 1122. A vertical doping concentration profile of the first sub-region 1121 and a vertical doping concentration profile of the second sub-region 1122 overlap each other at the bottom side 113 of the first sub-region 1121 (see also exemplary Figs. 5A, 5B). The shielding region 112 adjoins the second sidewall 1036 the trench gate structure 103.

The first sub-region 1121 at the bottom side of the trench structure 102 is bounded, along a first lateral direction x1, by opposite portions of the second sub-region 1122. A transition or interface between the first sub-region 1121 and the second sub-region 1122 vertically extends from a bottom side of the trench gate structure 103 and performs a U-turn. After the U-turn, the transition or interface extends up to a p⁺-doped contact region 118 at first surface 1061 of the wide band gap semiconductor body 104, e.g. parallel to the second sidewall 1036 of the trench gate structure 103. The p⁺-doped contact region 118 electrically connects the shielding region 112 to a source electrode S over the first surface 1061. The n+-doped source region 110 is also electrically connected to the source electrode S.

The IGFET 100 further includes an n-doped current spread region 114 and an n⁻-doped drift region 116. For example, the n⁻-doped drift region may be part of a semiconductor substrate having a background doping concentration or may be formed in a semiconductor layer on the semiconductor substrate. The n-doped current spread region 114 is arranged, along the vertical direction y, between the p-doped body region 108 and the n⁻-doped drift region 116. A maximum doping concentration of the n-doped current spread region 114 is larger than a maximum doping concentration of a portion of the n⁻-doped drift region 116 adjoining a bottom side of the n-doped current spread region 114. The n⁻-doped drift region 116 is electrically connected to a drain electrode D via a second surface of the wide band gap semiconductor body 104 that is opposite to the first surface 1061.

A further configuration example of an IGFET 100 is illustrated in the schematic cross-sectional view of Fig. 4. The IGFET 100 is an example of a an IGFET having a two-sided channel region.

The IGFET 100 includes a trench structure 102 extending, along a vertical direction y, into a wide band gap semiconductor body 104, e.g. SiC semiconductor body, from a first surface 1061 of the wide band gap semiconductor body 104. The trench structure 102 is configured as a contact trench structure 105 including a contact material 1051 electrically coupled to the p-doped shielding region 112. The p-doped shielding region 112 includes the first sub-region 1121 and the second sub-region 1122 similar to the example of Fig. 4A. However, the first sub-region 1121 of the p-doped shielding region 112 not only adjoins a bottom side and a second sidewall 1056 of the contact trench structure 105, but also a first sidewall 1055 of the contact trench structure 105.

The IGFET 100 further includes a trench gate structure 103 extending, along the vertical direction y, into the wide band gap semiconductor body 104 from the first surface 1061 of the wide band gap semiconductor body 104. The trench gate structure 103 includes a trench gate dielectric 1031 and a trench gate electrode 1032. A portion of the p-doped body region 108 is bounded, along a first lateral direction x1, by the trench gate structure 103 and the shielding region 112. A portion of the shielding region 112 is bounded, along the first lateral direction x1, by the body region 108 and the contact trench structure 105. The n+-doped source region 110 extends, along the first lateral direction x1, from the trench gate structure 103 to the contact trench structure 105. The n+-doped source region 110 may include sub-regions spaced from one another along a second lateral direction x2 that is perpendicular to the first lateral direction x1. For example, the second lateral direction x2 may be perpendicular to the drawing plane of Fig. 4. Although not illustrated in cross-sectional view of Fig. 4, between the sub-regions of the n+-doped source region 110, sub-regions of the p⁺-doped contact region 118 may extend along the first and second sidewalls 1055, 1056 of the contact trench structure 105 up to the first surface 1061 for electrically connecting the shielding region 112 to the source electrode S over the first surface 1061. The n+-doped source region 110 is also electrically connected to the source electrode S.

Similarto the IGFET 100 illustrated in Fig. 3, an n-doped current spread region 114 is arranged, along the vertical direction y, between the p-doped body region 108 and the n⁻-doped drift region 116. The n⁻-doped drift region 116 is electrically connected to the drain electrode D via a second surface of the wide band gap semiconductor body 104 that is opposite to the first surface 1061.

Exemplary doping concentration profiles of the shielding region 112 along lines AA' of Figs. 3 and 4 are illustrated in the graphs of Figs. 5A and 5B,

The graph of Fig. 5A illustrates an example of a profile of doping concentration c along the vertical direction y of line AA' of Figs. 3 and 4. The profile of doping concentration c includes a peak P in the second sub-region 1122 that has a vertical distance d to the bottom side 113 of the first sub-region 1121.

The graph of Fig. 5B illustrates a further example of a profile of doping concentration c along the vertical direction y of line AA' of Figs. 3 and 4. A maximum doping concentration c2m of the second sub-region 1122, along the vertical direction y starting from the bottom side 113 of the first sub-region 1121, is located at a transition to the first sub-region 1121 at the bottom side 113 of the first sub-region 1121.

As an example, for each of the exemplary profiles of doping concentration c illustrated in Figs. 5A, 5B, a maximum doping concentration c1m of the first sub-region 1121, along the vertical direction y starting from the bottom side of the trench structure 102, may be larger than 2 x 10¹⁸ cm⁻³, and a maximum doping concentration c2m of the second sub-region 1122, along the vertical direction y, starting from the bottom side 113 of the first sub-region 1121, may be smaller than 2 x 10¹⁸ cm⁻³.

The shielding region 112 may also be applied to other semiconductor device types. For example, the shielding region may be applied to an insulated gate bipolar transistor, IGBT having the source region 110 of Figs. 3, 4 replaced by an emitter region. A further example is illustrated in Fig. 6 for a vertical junction field effect transistor, VJFET 101. For example, the VJFET may be a trenched and implanted vertical-channel JFET, TI-VJFET.

The VJFET 101 includes a trench structure 102 extending into the wide band gap semiconductor body 104, e.g. SiC semiconductor body, from the first surface 1061. The trench structure 102 is laterally confined by mesa regions along the first lateral direction x1.

Each of the mesa regions includes an n-doped mesa channel region 120. A p-doped gate/shielding region 122 adjoins opposite sidewalls 1025, 1026 of the trench structure 102. The p-doped gate/shielding region 122 further adjoins a bottom side 1023 of the trench structure 102. The p-doped gate/shielding region 122 includes a first sub-region 1221 and a second sub-region 1222. Details described with respect to the shielding region of the IGFET likewise apply to the gate/shielding region of the VJFET.

The gate/shielding region 122 is electrically connected or coupled to a contact material 124 in the trench structure 102. The contact material includes conductive material, e.g. metal or highly doped semiconductor material, or any combination thereof, and may further include insulating material. The insulating material may, for example, be arranged between the conductive material and parts of the surrounding wide band gap semiconductor body 104.

A dielectric layer 126 is arranged over the contact material 124. The dielectric layer 126 extends, along the vertical direction y, from below the first surface 1061 toward, or up to or over the first surface 1061.

The aspects and features mentioned and described together with one or more of the previously described examples and figures, may as well be combined with one or more of the other examples in order to replace a like feature of the other example or in order to additionally introduce the feature to the other example.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. An insulated gate field effect transistor, IGFET (100), comprising:
a trench structure (102) extending, along a vertical direction (y), into a wide band gap semiconductor body (104) from a first surface (1061) of the wide band gap semiconductor body (104);
a body region (108) of a first conductivity type;
a source region (110) of a second conductivity type;
a shielding region (112) of the first conductivity type, wherein the shielding region (112) includes a first sub-region (1121) adjoining a bottom side of the trench structure (102), and a second sub-region (1122) adjoining a bottom side (113) of the first sub-region (1121), the first sub-region (1121) having a larger maximum doping concentration than the second sub-region (1122), and wherein a vertical doping concentration profile of the first sub-region (1121) and a vertical doping concentration profile of the second sub-region (1122) overlap each other at the bottom side (113) of the first sub-region (1121).

2. The IGFET (100) of the preceding claim, wherein a vertical doping concentration profile of the second sub-region (1122), starting from the bottom side (113) of the first sub-region (1121), corresponds to a space charge per unit area larger than 0.95 times a breakdown charge per unit area of the wide band gap semiconductor body (104).

3. The IGFET (100) of any of the preceding claims, wherein the wide band gap semiconductor body (104) is a silicon carbide semiconductor body, and a maximum doping concentration (c1m) of the first sub-region (1121), along the vertical direction (y) starting from the bottom side of the trench structure (102), is larger than 2 x 10¹⁸ cm⁻³, and a maximum doping concentration (c2m) of the second sub-region (1122), along the vertical direction (y) starting from the bottom side (113) of the first sub-region (1121), is smaller than 2 x 10¹⁸ cm⁻³.

4. The IGFET (100) of the preceding claim, wherein the vertical doping concentration profile of the second sub-region (1122), along the vertical direction (y) starting from the bottom side (113) of the first sub-region (1121), includes at least one peak (P) having a vertical distance (d) to the bottom side (113) of the first sub-region (1121).

5. The IGFET (100) of claim 3, wherein the maximum doping concentration (c2m) of the second sub-region (1122), along the vertical direction (y) starting from the bottom side (113) of the first sub-region (1121), is located at a transition to the first sub-region (1121) at the bottom side (113) of the first sub-region (1121).

6. The IGFET (100) of any of the preceding claims, wherein the trench structure (102) is a trench gate structure (103) including a trench gate dielectric (1031) and a trench gate electrode (1032).

7. The IGFET (100) of the preceding claim, wherein the source region (110) adjoins a first sidewall (1035) of opposite first and second sidewalls (1035, 1036) of the trench gate structure (103), the body region (108) adjoins the first sidewall (1035) of the trench gate structure (103), and the shielding region (112) adjoins the second sidewall (1036) the trench gate structure (103).

8. The IGFET (100) of any of the two preceding claims, wherein the first sub-region (1121) at the bottom side of the trench structure (102) is bounded, along a first lateral direction (x1), by opposite portions of the second sub-region (1122).

9. The IGFET (100) of any of claims 1 to 2, wherein the trench structure (102) is a contact trench structure (105) including a contact material (1051) electrically coupled to the shielding region (112).

10. The IGFET (100) of the preceding claim, further comprising a trench gate structure (103) extending, along the vertical direction (y), into the wide band gap semiconductor body (104) from the first surface (1061) of the wide band gap semiconductor body (104), the trench gate structure (103) including a trench gate dielectric (1031) and a trench gate electrode (1032), and wherein a portion of the body region (108) is bounded, along a first lateral direction (x1), by the trench gate structure (103) and the shielding region (112), and a portion of the shielding region (112) is bounded, along the first lateral direction (x1), by the body region (108) and the trench structure (102).

11. The IGFET (100) of any the preceding claims, further comprising a current spread region (114) of the second conductivity type and a drift region (116) of the second conductivity type, wherein the current spread region (114) is arranged, along the vertical direction (y), between the body region (108) and the drift region (116), and a maximum doping concentration of the current spread region (114) is larger than a maximum doping concentration of a portion of the drift region (116) adjoining a bottom side of the current spread region (114).

12. A method of manufacturing an insulated gate field effect transistor, IGFET (100), the method comprising:
forming a trench structure (102) extending, along a vertical direction (y), into a wide band gap semiconductor body (104) from a first surface (1061) of the wide band gap semiconductor body (104);
forming a body region (108) of a first conductivity type;
forming a source region (110) of a second conductivity type;
forming a shielding region (112) of the first conductivity type, wherein the shielding region (1121) includes a first sub-region (1121) adjoining a bottom side of the trench structure (102), and a second sub-region (1122) adjoining a bottom side (113) of the first sub-region (1121), the first sub-region (1121) having a larger maximum doping concentration than the second sub-region (1122), and wherein a vertical doping concentration profile of the first sub-region (1121) and a vertical doping concentration profile of the second sub-region (1122) overlap each other at the bottom side (113) of the first sub-region (1121).

13. The method of the preceding claim, wherein forming the first sub-region (1121) includes at least one ion implantation process having a first ion implantation energy (E1) and a first ion implantation tilt angle (α1) and forming the second sub-region (1122) includes at least one ion implantation process having a second ion implantation energy (E2) and a second ion implantation tilt angle (α2).

14. The method of the preceding claim, wherein the second ion implantation energy (E2) is at least 50 % larger than the first ion implantation energy (E1), and the second ion implantation tilt angle (α2) is smaller than the first ion implantation tilt angle (α1).

15. The method of any of the two preceding claims, wherein a total ion implantation dose of the at least one ion implantation process for forming the second sub-region (1122) is in a range from 3 x 10¹³ cm⁻² to 1 x 10¹⁴ cm⁻².
